# FASCICULE DE BREVET EUROPEEN

(11) **EP 3 443 599 B1**
(45) Date de publication et mention de la délivrance du brevet: **22.07.2020**
(21) Numéro de dépôt: 17722491.2
(22) Date de dépôt: 14.04.2017
(51) Int. Cl.: H01L 41/00, H01L 41/06

(54) **GENERATEUR D'ELECTRICITE COMPRENANT UN CONVERTISSEUR MAGNETO-ELECTRIQUE ET PROCEDE DE FABRICATION ASSOCIE**
STROMGENERATOR MIT MAGNETOELEKTRISCHEM WANDLER UND VERFAHREN ZU DESSEN HERSTELLUNG
ELECTRICITY GENERATOR COMPRISING A MAGNETOELECTRIC CONVERTER AND MANUFACTURING METHOD THEREFOR

(30) Priorité: 15.04.2016 FR 1653357
(43) Date de publication de la demande: 20.02.2019
(73) Titulaire: Enerbee, 38040 Grenoble (FR)
(72) Inventeur: DELAMARE, Jérôme, 38950 Quaix-en-Chartreuse (FR); RICART, Thibault, 38170 Seyssinet Pariset (FR); GUILLEN, Jérémie, 38100 Grenoble (FR); VINCENT, Maxime, 38000 Grenoble (FR)
(74) Mandataire: IP Trust
(86) Numéro de dépôt international: PCT/FR2017/050904
(87) Numéro de publication internationale: WO 2017/178772

(56) Documents cités:
- WO-A1-2015/059421
- US-B1- 9 091 251

## Description

### DOMAINE DE L'INVENTION

La présente invention concerne le domaine des dispositifs pour la récupération d'énergie. Elle concerne en particulier un générateur d'électricité et un convertisseur apte à convertir une variation d'énergie magnétique en une différence de potentiel, ainsi qu'un procédé de fabrication associé. Le convertisseur magnéto-électrique comprend un empilement de couches de matériaux magnétostrictif et piézoélectrique.

### ARRIERE PLAN TECHNOLOGIQUE DE L'INVENTION

La magnétostriction correspond, en général, à un échange réversible d'énergie d'une forme mécanique à une forme magnétique. L'effet le plus connu relatif à la magnétostriction est l'effet Joule. Il correspond à l'expansion, dans le cas d'un coefficient de magnétostriction positif, ou à la contraction, dans le cas d'un coefficient négatif, d'un barreau ferromagnétique sous l'influence d'un champ magnétique. En l'absence de champ magnétique, le barreau revient théoriquement à sa forme initiale. Dans le cas d'une expansion longitudinale dans le sens du champ magnétique, une contraction apparaît dans les directions transversales de manière à conserver le volume du barreau sensiblement constant.

Lorsque les lignes de champ magnétique saturent magnétiquement le bloc en matériau magnétostrictif, la déformation est maximale selon un axe parallèle à ces lignes de champ, que le matériau soit isotrope ou anisotrope. Lorsque un bloc en matériau magnétostrictif anisotrope n'est pas saturé magnétiquement, il présente un axe préférentiel de déformation qui est une propriété intrinsèque du bloc, dépendant de l'orientation cristalline du matériau. Par axe préférentiel de déformation, on désigne l'axe le long duquel l'amplitude de la déformation est maximale en présence d'un champ magnétique parallèle à cet axe. Les termes « axe préférentiel de déformation » et « axe préférentiel d'aimantation », désignent les mêmes axes, et seront donc utilisés de manière interchangeable dans la suite de ce texte.

La piézoélectricité correspond à la génération de charges électriques sous l'influence d'une contrainte mécanique. Parmi les matériaux piézoélectriques, on connaît notamment le PZT (alliage de Plomb, Zirconium et Titane). Le PZT, muni de deux électrodes, peut être pré-polarisé, grâce à un traitement thermique à une température sensiblement inférieure à sa température de Curie, pendant lequel une tension est appliquée aux électrodes. L'axe de polarisation du matériau est alors établi selon une direction allant de l'une à l'autre des électrodes. Cette polarisation détermine notamment sur quelle électrode va apparaître un excédent de charges électriques en réponse à une contrainte appliquée au matériau piézoélectrique. En considérant une couche de matériau PZT, comportant une face supérieure et une face inférieure parallèles, l'axe de polarisation peut être orienté selon une direction perpendiculaire aux faces du fait de la présence d'une électrode sur chaque face. Alternativement, l'axe de polarisation peut être orienté selon une direction parallèle aux faces, en utilisant notamment des électrodes inter-digitées sur au moins l'une des deux faces de la couche. Dans ce dernier cas, l'axe de polarisation est parallèle au plan des faces et perpendiculaire aux doigts de matériau conducteur formant les électrodes interdigitées. Pour convertir une contrainte / déformation en différence de potentiel aux bornes des électrodes, on peut donc se placer dans l'un des deux modes particuliers selon que la déformation est perpendiculaire à l'axe de polarisation (mode appelé d₃₁) ou selon que la déformation est parallèle à l'axe de polarisation (mode appelé d₃₃).

On connaît de l'état de la technique (article de T.Lafont et al, « Magnetostrictive-piezoelectric composite structures for energy harvesting », Journal of Micromechanics and Microengineering, n°22, 2012), des générateurs d'électricité comportant une source de champ magnétique dont les lignes de champ sont parallèles à un plan de référence, et un convertisseur magnéto-électrique apte à convertir une variation du champ magnétique en une différence de potentiel entre deux bornes électriques. Le convertisseur est composé d'une part, d'un transducteur électromécanique comprenant une couche piézoélectrique apte à transformer une déformation mécanique en une différence de potentiel entre deux bornes électriques reliées à ses électrodes. Le convertisseur est composé d'autre part d'une couche magnétostrictive fixée selon le plan de référence et sans degré de liberté au transducteur électromécanique, apte à convertir une variation du champ magnétique en une déformation mécanique, exercée sur le transducteur électromécanique.

Dans le cas d'un aimant permanent animé d'un mouvement de rotation au-dessus du convertisseur (permettant de faire varier l'orientation du champ magnétique dans le plan de référence), ce document préconise l'utilisation d'un matériau magnétostrictif isotrope, et en particulier le FeSiB (alliage à base de Fer, Silicium et Bore). Dans ce cas, l'axe préférentiel de déformation de la couche magnétostrictive suit l'orientation du champ magnétique dans le plan de référence et n'oppose aucun couple en réaction à la rotation de l'aimant.

Cependant, ce matériau présente un coefficient magnétostrictif très faible, ce qui conduit à une faible efficacité de conversion du convertisseur. L'efficacité de conversion du convertisseur est définie comme la quantité d'énergie électrique générée (c'est-à-dire la différence de potentiel entre les deux bornes électriques) par rapport à une variation donnée de l'énergie à récupérer (variation du champ magnétique).

Les matériaux connus présentant des coefficients magnétostrictifs plus importants sont anisotropes (par exemple, le Terfenol de composition TbDyFe, un alliage de fer et de terres rares). On connaît de l'état de la technique, notamment WO2015/059421 et WO2015/059422, des générateurs d'électricité utilisant ce type de matériaux.

Ces matériaux magnétostrictifs nécessitent un champ magnétique suffisamment important pour être saturés, et fonctionner ainsi dans un domaine de déformation isotrope. La dimension importante de la source de champ magnétique ne permet alors plus de préserver la compacité du générateur.

### OBJET DE L'INVENTION

Un objet de l'invention est de proposer un dispositif et un procédé remédiant à tout ou partie des inconvénients de l'art antérieur. Un objet de l'invention est notamment de proposer un convertisseur magnéto-électrique efficace dans un générateur électrique compact. En d'autres termes, l'invention vise à diminuer l'encombrement d'un générateur à efficacité constante ou, à encombrement constant, à augmenter l'efficacité du générateur.

### BREVE DESCRIPTION DE L'INVENTION

L'invention concerne tout d'abord un empilement de couches selon la revendication indépendante de dispositif 1.

Une source de champ magnétique et un convertisseur du générateur comprenant l'empilement de couches peuvent se déplacer en rotation l'un par rapport à l'autre de manière à faire varier l'orientation du champ magnétique dans le plan de référence.

La source de champ magnétique peut présenter des dimensions réduites car le générateur selon l'invention ne requiert pas les fortes intensités de champ nécessaires pour saturer le matériau magnétostrictif anisotrope ; ainsi le générateur peut répondre au besoin de compacité. La première couche en matériau magnétostrictif est choisie parmi les matériaux anisotropes qui présentent de forts coefficients magnétostrictifs, ce qui permet de favoriser la sensibilité de conversion. Celle-ci est maximisée par un alignement contrôlé de l'axe préférentiel de déformation de la première couche avec l'axe de polarisation de la deuxième couche. Une déformation maximale (en présence d'un champ magnétique parallèle à l'axe préférentiel de déformation de la première couche) sera transmise à la deuxième couche piézoélectrique selon son axe de polarisation (aligné à 15° près avec l'axe préférentiel de déformation), c'est-à-dire dans une configuration très efficace pour la génération de charges. Le générateur selon l'invention apporte donc des avantages tant en terme de compacité que d'efficacité de conversion.

Notamment la source de champ magnétique définit un logement dans lequel règne le champ magnétique, le convertisseur étant placé dans le logement et la source de champ magnétique est un cylindre d'Halbach ; Cette configuration de la source de champ magnétique autorise une taille réduite du générateur.

L'alignement à 15° près entre l'axe préférentiel de déformation de la première couche et l'axe de polarisation de la deuxième couche, requis pour former un générateur efficace, est rendu possible par la couche de matériau magnétostrictif selon l'invention : en effet, celle-ci comporte les moyens de repérage nécessaires à la mise en œuvre de cet alignement contrôlé.

Selon des caractéristiques avantageuses de l'invention, prises seules ou en combinaison :
- l'empilement de couches comprend une couche de collage entre la première couche et la deuxième couche ;
- la deuxième couche comprend des électrodes métalliques sur l'une au moins de ses faces ou sur sa tranche ;
- l'empilement de couches comprend une troisième couche en un matériau piézoélectrique présentant un deuxième axe de polarisation dans le plan défini par la troisième couche, la première couche étant disposée entre la deuxième couche et la troisième couche, le deuxième axe de polarisation et l'axe préférentiel de déformation étant alignés à 15° près ;
- la première couche en un matériau magnétostrictif comprend un axe principal de déformation et un axe secondaire de déformation dans le plan défini par la couche ;
- le premier axe de polarisation de la deuxième couche en un matériau piézoélectrique est aligné à 15° près avec l'axe principal de déformation ;
- le deuxième axe de polarisation de la troisième couche en un matériau piézoélectrique est aligné à 15° près avec l'axe secondaire de déformation ;
- le matériau piézoélectrique est composé de PZT, de PMN-PT, de PVDF, de BaTiO3 ou encore d'AIN ;
- le matériau magnétostrictif est composé de Terfenol-D, de Galfenol, de Terbium Fer ou encore de Fer-Cobalt.

L'invention concerne également un convertisseur apte à convertir une variation d'un champ magnétique en une différence de potentiel entre deux bornes électriques comprenant un empilement de couches tel que ci-dessus.

Selon des caractéristiques avantageuses de l'invention, l'étape d'identification de l'axe préférentiel de déformation comprend :
- Le positionnement de la couche dans un champ magnétique orienté dans le plan de référence ;
- La mesure des couples requis pour déplacer la couche en rotation dans le plan de référence, en une pluralité de positions angulaires ;
- La détermination d'au moins une position angulaire correspondant à un extremum de couple, pour identifier un axe préférentiel de déformation.

L'invention concerne également un procédé de fabrication d'un empilement de couches selon la revendication indépendante 12, comportant :
- une étape de fourniture d'une première couche de matériau magnétostrictif anisotrope ;
- une étape d'identification d'au moins un axe préférentiel de déformation dans le plan de référence défini par la première couche ;
- une étape de fourniture d'une deuxième couche d'un matériau piézoélectrique présentant un premier axe de polarisation dans un plan défini par la deuxième couche et repéré par une deuxième marque ;
- une étape d'alignement de l'axe préférentiel de déformation de la première couche avec le premier axe de polarisation de la deuxième couche ;
- une étape d'assemblage de la première couche avec la deuxième couche pour former l'empilement de couches.

L'invention concerne enfin un procédé d'assemblage d'un générateur d'électricité selon la revendication 15, comprenant :
- la fabrication d'un empilement de couches, la première couche définissant un plan de référence ;
- l'assemblage de l'empilement de couches avec une couche de circuit imprimé, pour connecter la au moins une couche de matériau piézoélectrique à deux bornes électriques et former le convertisseur magnéto-électrique ;
- le placement du convertisseur dans un logement défini par une source de champ magnétique, dans lequel règne un champ, une partie des lignes du champ étant comprise dans le plan de référence.

### BREVE DESCRIPTION DES DESSINS

D'autres caractéristiques et avantages de l'invention ressortiront de la description détaillée de l'invention qui va suivre en référence aux figures annexées sur lesquelles :
- la figure 1 présente un schéma de principe d'un générateur d'électricité conforme à l'invention ;
- les figures 2a et 2b présentent un exemple de fabrication de couche d'un matériau magnétostrictif ;
- la figure 3a présente une cartographie de l'aimantation dans une couche d'un matériau magnétostrictif soumise à un champ magnétique de direction variable, en fonction des orientations cristallines dans la couche ;
- la figure 3b présente un schéma de principe de la variabilité de l'orientation d'un axe préférentiel d'aimantation entre plusieurs couches d'un matériau magnétostrictif ;
- les figures 4a à 4c présentent un procédé de traitement d'une couche d'un matériau magnétostrictif, conforme à l'invention ;
- la figure 5 présente une couche de matériau magnétostrictif conforme à l'invention ;
- les figures 6a à 6c présentent une couche d'un matériau magnétostrictif et des couches d'un matériau piézoélectrique utilisées pour la fabrication d'un empilement de couches conforme à l'invention ;
- les figures 7a à 7f présentent un procédé de fabrication d'un empilement de couches conforme à l'invention ;
- les figures 8a à 8c présentent un procédé de fabrication d'une structure de convertisseur conforme à l'invention ;
- les figures 9a à 9c présentent un schéma de principe du fonctionnement d'un générateur d'électricité compact conforme à l'invention.

### DESCRIPTION DETAILLEE DE L'INVENTION

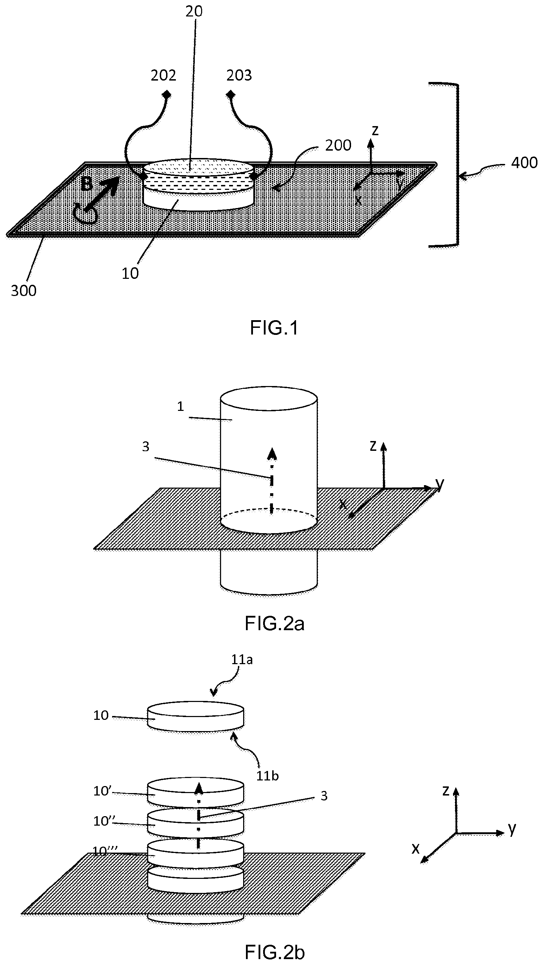

La figure 1 représente un schéma de principe d'un générateur 400 d'électricité conforme à l'invention. Il comporte une source 300 de champ magnétique et un convertisseur magnéto-électrique 200 apte à convertir une variation du champ magnétique B en une différence de potentiel entre des bornes électriques. Le convertisseur 200 comprend deux bornes électriques 202,203 et un empilement 100 formé d'une première couche 10 en matériau magnétostrictif définissant un plan de référence (x,y) et d'une deuxième couche 20 en un matériau piézoélectrique. Une partie des lignes du champ magnétique B est parallèle au plan de référence (x,y). La source 300 de champ magnétique et le convertisseur 200 peuvent se déplacer en rotation l'un par rapport à l'autre de manière à faire varier l'orientation du champ magnétique B dans le plan de référence.

Selon l'invention, pour limiter l'encombrement du générateur 400 (par exemple de l'ordre du centimètre cube), la dimension de la source 300 de champ magnétique est réduite, et génère ainsi un champ magnétique B dont l'intensité est relativement faible, c'est-à-dire insuffisante pour saturer magnétiquement le matériau de la couche 10. L'intensité du champ peut être par exemple de l'ordre de 0,3 Tesla, ou compris entre 0,1 et 0,6 Tesla. Avantageusement, le matériau magnétostrictif est choisi pour présenter un coefficient magnétostrictif important, par exemple supérieur à 100ppm. Il peut s'agir de Terfenol, du Galfenol, de Terbium Fer ou encore de Fer-Cobalt, sous leurs formes cristallines. Dans un domaine non saturé de magnétisation, ces matériaux sont anisotropes et présentent donc un ou des axes préférentiels de déformation.

Selon un aspect avantageux de l'invention, et pour répondre aux besoins de compacité, la source 300 est munie d'un logement dans lequel règne le champ magnétique B et dans lequel le convertisseur 200 est placé. A titre d'exemple, la source 300 de champ magnétique peut être un aimant permanent, par exemple un cylindre de Halbach.

Pour améliorer l'efficacité de conversion et/ou d'encombrement du générateur 400, il est avantageux de prendre en compte la caractéristique d'anisotropie du matériau magnétostrictif en régime non saturé. Le générateur selon l'invention est remarquable en ce que l'axe préférentiel de déformation de la première couche 10 en matériau magnétostrictif a été aligné avec l'axe de polarisation de la seconde couche 20 en un matériau piézoélectrique. De la sorte, on assure que toute déformation de la première couche 10, imposant la déformation de la deuxième couche 20, conduise à la génération optimale de charges dans cette deuxième couche 20 et à la création d'une différence de potentiel maximale aux bornes 202,203 du convertisseur 200. Toutefois, l'axe préférentiel de déformation de la première couche 10 n'est pas une information usuellement et facilement disponible, comme le montrent les expérimentations préliminaires menées par la demanderesse.

### Observations préliminaires

Pour obtenir des couches 10 en matériau magnétostrictif, on forme dans un premier temps un barreau 1 de matériau magnétostrictif selon une méthode connue, par exemple par fusion de zone verticale (FSZM pour « Free-Stand Zone Melt ») ou par la méthode « Brigman modifié ». Comme illustré sur la figure 2a, l'axe longitudinal 3 du barreau 1 est aligné avec l'axe préférentiel de déformation du barreau 1 (qui est l'axe <112> pour les barreaux de Terfenol). Il est d'usage, selon l'art antérieur, de former des couches dans un plan parallèle à cet axe. Toutefois, selon un aspect de l'invention, les couches 10 de matériau magnétostrictif sont préférentiellement fabriquées à partir de découpes transversales du barreau 1, ainsi que cela est représenté sur la figure 2b. On utilise de la sorte une majeure partie du barreau 1 pour former une pluralité de couches 10, 10', 10".... Chaque découpe transversale peut être traitée par rodage, polissage, détourage, traitement des bords... pour fournir une couche 10 présentant la qualité et les dimensions requises. Un barreau 1 de matériau magnétostrictif peut ainsi fournir une pluralité de couches 10, 10', 10" dont les faces 11a, 11b sont essentiellement parallèles à un plan de référence (x,y). Pour marquer l'orientation de chacune des couches 10, 10', 10" issues du barreau 1, un méplat d'orientation peut être formé sur le barreau 1 selon son axe longitudinal, suite à sa formation et préalablement à la découpe des sections transversales.

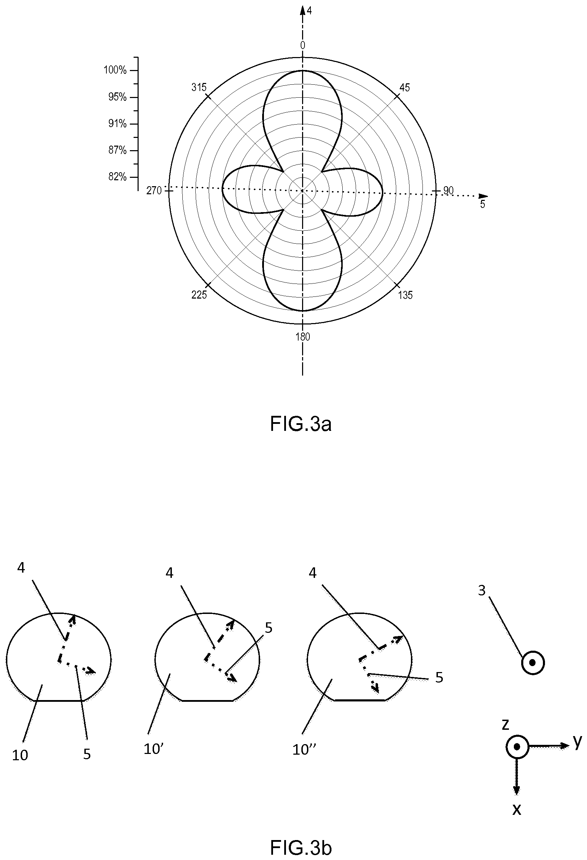

Afin de caractériser les couches 10, 10', 10" obtenues selon cette méthode et d'illustrer l'effet du caractère anisotrope de ces couches, la demanderesse a mesuré les niveaux de magnétisation générés dans une couche 10 de Terfenol-D, dans différentes directions correspondant à différentes positions angulaires (0° à 360° par rapport au méplat d'orientation), lors de l'application d'un champ magnétique uniforme parallèle à chaque direction. Le niveau de magnétisation est déterminé par une mesure de tension générée aux bornes d'une bobine dans laquelle la couche 10 opère un mouvement vibratoire. L'intensité du champ magnétique était de 159.15 kA/m (2 kOe), ce qui n'est pas suffisant pour saturer magnétiquement le matériau. La figure 3a montre qu'il existe, pour une couche 10 de Terfenol-D, deux axes préférentiels d'aimantation 4, 5 pour lesquels le niveau de magnétisation est plus élevé comparativement aux autres directions. L'axe principal est l'axe 4, il présente le niveau de magnétisation maximal, supérieur à celui de l'axe secondaire 5. L'axe principal 4, dans le cas du Terfenol-D, est aligné sur l'axe cristallographique <111> ; l'axe secondaire 5 est aligné sur l'axe cristallographique <110>. On observe également qu'en-dehors des directions des axes préférentiels 4, 5, le niveau de magnétisation du Terfenol-D est jusqu'à 15%-20% moindre.

En répétant ce protocole de mesure sur une pluralité de couches 10, 10', 10" issues d'un même barreau 1 de Terfenol, la demanderesse a observé que les orientations des axes préférentiels d'aimantation des couches 10, 10', 10" pouvaient varier d'une couche à l'autre. Ceci est illustré sur la figure 3b sur laquelle on observe que la position des axes préférentiels 4, 5 de chacune des couches 10, 10', 10" vis-à-vis du méplat d'orientation originellement formé sur le barreau 1 n'est pas identique. Ainsi, les techniques habituelles de marquage, comme la réalisation d'un méplat ou d'une encoche sur le barreau 1, suite à sa croissance et préalablement à la découpe des sections transversales ne permettent pas de repérer les axes préférentiels d'aimantation des couches 10, 10', 10".

### Traitement de la couche en matériau magnétostrictif

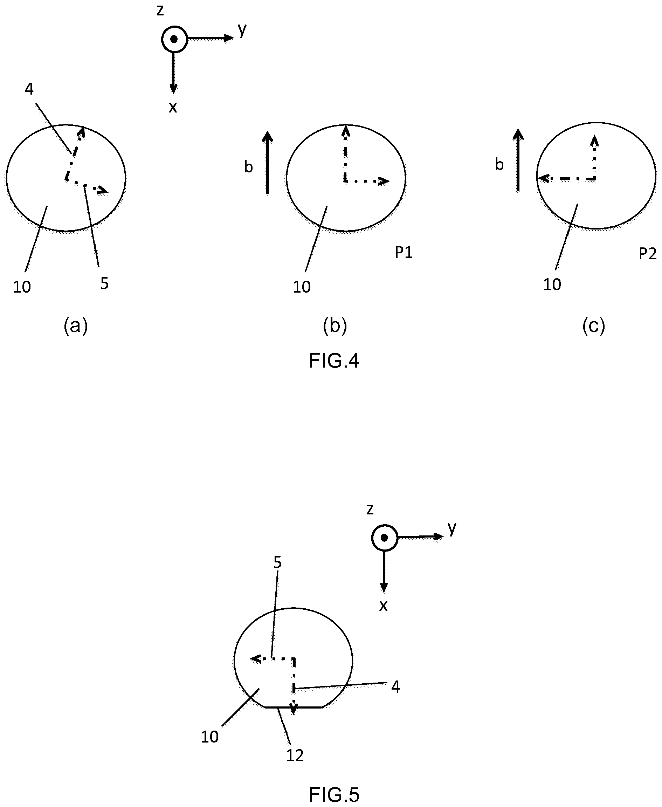

Pour résoudre ce problème et permettre l'assemblage aligné d'une couche 10, l'invention prévoit le traitement de la couche 10 en matériau magnétostrictif anisotrope. Cette couche 10 peut provenir de la découpe transversale d'un barreau 1 de matériau magnétostrictif, comme cela a été exposé dans les paragraphes précédents. Le traitement comprend tout d'abord une étape d'identification d'au moins un axe préférentiel d'aimantation 4,5 dans un plan de référence défini par la couche 10 (figure 4a), c'est-à-dire parallèle aux faces 11a et 11b de la couche 10.

A titre d'exemple cette étape d'identification de l'axe préférentiel d'aimantation peut comprendre :
- Le positionnement de la couche 10 dans un champ magnétique b orienté selon une direction donnée dans le plan de référence. La couche 10 ayant une liberté de mouvement en rotation, elle pourra naturellement aligner un de ses axes préférentiels d'aimantation 4,5 avec la direction du champ magnétique b, cette position correspondant à une première position stable (nommée P1 sur la figure 4b) ;
- La mesure des couples requis pour déplacer la couche 10 en rotation dans le plan de référence, en une pluralité de positions angulaires successives. On effectue par exemple une mesure du couple requis pour imposer un mouvement de rotation à la couche 10 d'une première position stable P1 (figure 4b) à une deuxième position stable P2 (figure 4c) ;
- La détermination d'au moins une position angulaire correspondant à un extremum de couple, pour identifier un axe préférentiel d'aimantation. Les positions stables permettent d'identifier les axes préférentiels d'aimantation. La position stable P1 correspondant à l'axe principal d'aimantation 4 demande plus d'effort pour s'en extraire que la position P2 correspondant à l'axe secondaire d'aimantation 5 : cette différence de couple permet de discriminer les axes préférentiels quand il en existe plusieurs dans le plan de la couche 10.

Selon un deuxième exemple, l'étape d'identification de l'axe préférentiel d'aimantation peut consister en le repérage des axes cristallographiques de la couche 10, par exemple par une mesure par rayon X.

Selon un troisième exemple, l'axe préférentiel d'aimantation peut être obtenu en mesurant pour chaque couche 10 le niveau de magnétisation en différentes positions angulaires par application de la méthodologie décrite sur la figure 3a.

Le traitement de la couche 10 peut également comprendre une étape de formation d'une marque 12 sur la couche 10 pour repérer au moins un axe préférentiel d'aimantation 4,5. Avantageusement, l'axe principal d'aimantation 4 sera repéré par une marque 12 en bord de couche, comme par exemple un méplat (comme illustré sur la figure 5), un trait, une gravure (par exemple effectué(e) par gravure chimique ou laser) ou une encoche...

Selon les cas, la marque 12 pourra être positionnée directement sur l'axe préférentiel d'aimantation d'intérêt ou à une position angulaire déterminée par rapport à cet axe (par exemple, à 90°, à 45°, à 30°...) . En tout état de cause, et quelle que soit la forme ou la position de cette marque 12, celle-ci permet de repérer un axe préférentiel d'aimantation 4, 5 de la couche 10.

A l'issue de ce traitement, on dispose d'une couche 10 de matériau magnétostrictif anisotrope comportant au moins un axe préférentiel d'aimantation 4,5 dans le plan défini par la couche 10, et comprenant au moins une marque 12 repérant un axe préférentiel de déformation 4,5.

De manière alternative, l'étape de formation d'une marque 12 peut être remplacée par la mise en œuvre d'une orientation magnétique qui sera décrite plus en détail en référence à l'élaboration de l'empilement formant le convertisseur.

### Empilement formant le convertisseur

Comme on l'a vu en relation avec la figure 1, le convertisseur 200 est constitué d'un empilement formé d'une première couche 10 en matériau magnétostrictif et d'une deuxième couche 20 en un matériau piézoélectrique. Selon un aspect de l'invention, pour les raisons d'efficacité de conversion déjà évoquées, un axe préférentiel de déformation 4,5 de la première couche 10 est aligné à mieux que 15° avec l'axe de polarisation de la deuxième couche 20.

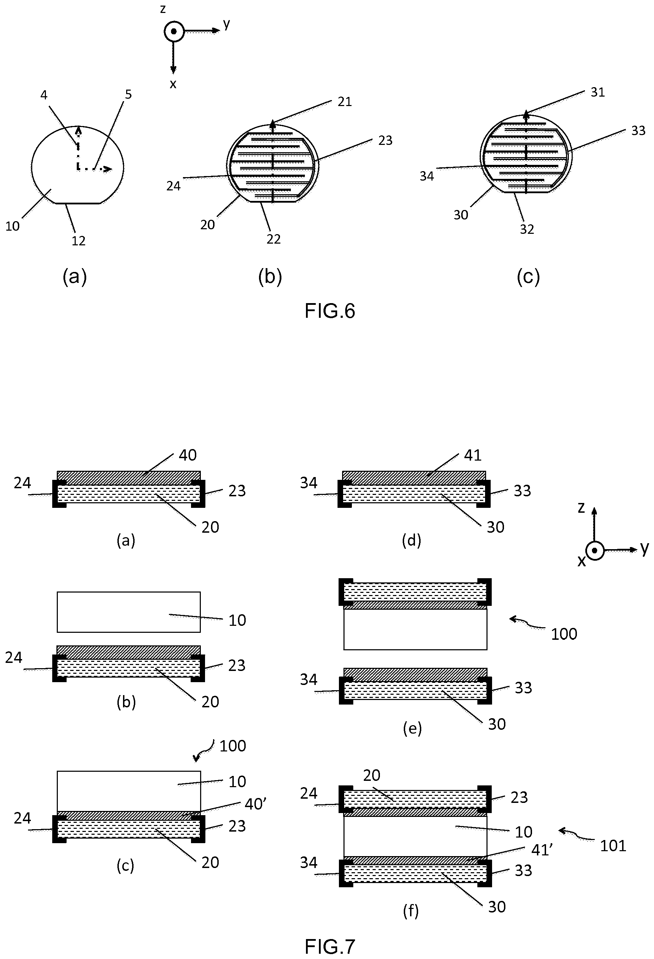

Le procédé de fabrication de l'empilement 100 comprend la fourniture d'une couche 10, comprenant au moins une marque 12 repérant un axe préférentiel de déformation 4,5 (figure 6a) . Il comprend également une étape de fourniture d'une deuxième couche 20 d'un matériau piézoélectrique présentant un axe de polarisation 21 dans un plan défini par la deuxième couche 20 (figure 6b) . L'une au moins des faces de la deuxième couche 20 comporte des électrodes, de préférence des électrodes interdigitées 23,24. Dans ce cas, son axe de polarisation 21 est parallèle au plan des faces de la deuxième couche 20 et perpendiculaire aux doigts de matériau conducteur formant les électrodes interdigitées 23,24. La couche 20 de matériau piézoélectrique est donc préférentiellement préparée pour fonctionner en mode d₃₃, qui est avantageusement plus sensible que le mode d₃₁, ce qui contribue à améliorer l'efficacité du convertisseur.

Selon une première option, les électrodes 23,24 pourront être formées par un matériau conducteur en contact avec la face de la deuxième couche 20 ; la pluralité de doigts de chaque électrode pourra être connectée par un segment en arc de cercle, comme illustré sur la figure 6b, dans le cas notamment d'une deuxième couche 20 de forme circulaire.

Selon une deuxième option, les doigts de chaque électrode pourront être connectés deux à deux par un élément conducteur, par exemple un câblage filaire, au niveau de la face de la deuxième couche 20 ou au niveau de sa tranche : cette configuration permet notamment d'augmenter la dimension des doigts (par exemple jusqu'aux bords de la deuxième couche 20) et donc de développer la partie active de collection de charges sur une surface plus importante de la face de la deuxième couche 20.

Selon une troisième option, les électrodes 23,24 pourront être formées par un matériau conducteur, disposé dans l'épaisseur de la deuxième couche 20 : chaque doigt d'une électrode présent sur une face de la deuxième couche 20 se prolonge dans l'épaisseur de celle-ci, formant une lame traversante en matériau conducteur. On pourra par exemple faire référence à des techniques de fabrication de multicouches piézoélectriques (« multilayer piezoelectric stack » selon la terminologie anglo-saxonne) pour l'élaboration de la deuxième couche 20 selon cette troisième option. Cette configuration permet de maximiser l'efficacité de collecte de charges car elle exploite l'intégralité de l'épaisseur de la deuxième couche 20. Cette troisième option peut incorporer l'un ou l'autre des modes de connexion des doigts de chaque électrode décrits dans les premières et deuxièmes options précitées, sans bien sur que cela soit limitatif.

La géométrie des électrodes 23,24 de la deuxième couche 20 permet de repérer l'axe de polarisation 21 et peut constituer une marque (dite deuxième marque 22). Facultativement, on peut former un méplat, un trait ou une encoche sur la deuxième couche 20, représentant la deuxième marque 22, pour identifier cet axe 21. On peut également faire porter la deuxième marque 22 par l'une au moins des électrodes, en lui donnant localement une forme qui peut être facilement repérée.

Le procédé de fabrication de l'empilement de couches 100 comprend une étape d'alignement d'un axe préférentiel de déformation 4,5 de la première couche 10 (avantageusement l'axe principal 4) avec l'axe de polarisation 21 de la deuxième couche 20 ; cet axe de polarisation 21 sera nommé « premier axe de polarisation » pour plus de clarté dans la suite de la description. Cette étape d'alignement se fera en particulier au moyen des marques 12 et 22, respectivement présentes sur la première couche 10 et la deuxième couche 20. Les marques 12 et 22 seront agencées de sorte que l'axe préférentiel de déformation (en particulier l'axe principal 4 de déformation) soit aligné à mieux que 15° avec le premier axe de polarisation 21.

L'axe préférentiel de déformation 4,5 et le premier axe de polarisation 21 étant contenus dans des plans sensiblement parallèles (respectivement le plan de référence défini par la première couche 10 et le plan défini par la deuxième couche 20), l'alignement entre ces deux axes consiste à limiter l'angle qu'ils forment entre eux, dans une vue planaire selon le plan de référence. Dis autrement, l'angle que forment les projections de ces axes sur le plan de référence est inférieur à 15°, selon l'invention, et ce grâce à l'étape d'alignement. Dans la suite de la description, un alignement entre les axes à « α° près » ou à « mieux que α° » devra être interprété comme équivalent à un angle inférieur à α° entre les projections de ces axes sur le plan de référence.

Avantageusement, l'axe préférentiel de déformation et l'axe de polarisation seront alignés à 10° près, voire à 5° près.

Selon une variante, l'étape d'alignement de l'axe préférentiel de déformation et de l'axe de polarisation pourra être opérée par alignement optique entre la marque 12 sur la couche 10 et les doigts interdigités des électrodes 23,24, puisque l'axe de polarisation 21 peut être repéré par rapport à ceux-ci : les doigts interdigités des électrodes 23,24 constituent dans cette variante la deuxième marque 22.

Selon une autre variante, l'étape d'alignement de l'axe préférentiel de déformation 4,5 pourra être basée sur la mise en œuvre d'une orientation magnétique : selon le mode opératoire décrit en relation avec les figures 4a à 4c, la couche en matériau magnétostrictif 10 pourra être soumise à un champ magnétique et laissée libre en rotation pour qu'elle aligne spontanément un de ses axes préférentiels de déformation avec le champ magnétique appliqué dans le plan de la couche. Cette position pourra ensuite être maintenue, par exemple par un dispositif de préhension de la couche 10 pour aligner l'axe de polarisation de la couche 20, jusqu'à l'étape d'assemblage suivante. Dans cette variante, la première marque 12 repérant un axe préférentiel de déformation n'est pas physiquement présente sur la couche 10 mais est remplacée par un moyen de repérage comprenant le dispositif de préhension de la couche 10, avant son assemblage avec le couche 20.

Le procédé de fabrication de l'empilement de couches 100 comprend une étape d'assemblage de la première couche 10 avec la deuxième couche 20. L'étape d'assemblage pourra comprendre, d'une part, l'étalement d'un film ou d'un serpentin de colle 40 sur l'une au moins des deux faces à assembler, respectivement de la première couche 10 ou de la deuxième couche 20. Cette étape d'étalement pourra être opérée préalablement à l'étape d'alignement, l'étape d'alignement étant faite de sorte que les faces à assembler, dont l'une au moins est munie de colle, ne se touchent pas.

Les figures 7a à 7f présentent un tel exemple de réalisation : le film de colle 40 est étalé sur la deuxième couche 20 (figure 7a) ; la première couche 10 est ensuite agencée en vis-à-vis de la deuxième couche 20, de manière à aligner à mieux que 15° l'axe principal de déformation 4 avec le premier axe de polarisation 21 (figure 7b). D'autre part, l'étape d'assemblage comprend la mise en contact des faces à assembler des couches 10 et 20 (figure 7c) . Pour obtenir une couche uniforme de colle 40' à l'interface entre les deux couches, une pression uniforme sera appliquée de manière à rapprocher les deux couches entre elles, en conservant un alignement entre l'axe principal de déformation 4 et le premier axe de polarisation 21 à moins de 15° près.

L'empilement de couches 100 est ainsi constitué de la première couche 10 de matériau magnétostrictif assemblée à la deuxième couche 20 de matériau piézoélectrique, cette dernière étant munie d'électrodes 23,24 sur l'une au moins de ses faces. L'empilement de couches 100 est remarquable en ce que le désalignement entre un axe préférentiel de déformation 4,5 (avantageusement l'axe principal de déformation 4) de la première couche 10 et le premier axe de polarisation 21 de la deuxième couche 20 est inférieur à 15°. Avantageusement, ce désalignement est même inférieur à 10°, voire à 5°.

Selon une variante, le procédé de fabrication d'un empilement de couches 101 comprend une étape de fourniture d'une troisième couche 30 d'un matériau piézoélectrique présentant un axe de polarisation 31 dans un plan défini par la troisième couche 30 et optionnellement repéré par une troisième marque 32 (figure 6c) . Avantageusement, l'une au moins des faces de la troisième couche 30 comporte des électrodes interdigitées 33,34 et l'axe de polarisation 31 est parallèle au plan desdites faces et en particulier, perpendiculaire aux doigts de matériau conducteur formant les électrodes interdigitées 33,34.

Le procédé de fabrication comprend également une étape d'alignement d'un axe préférentiel de déformation 4,5 de la première couche 10 (avantageusement l'axe principal de déformation 4, mais de manière alternative, l'axe secondaire de déformation 5) avec l'axe de polarisation 31 de la troisième couche 30. Cet axe de polarisation sera nommé « deuxième axe de polarisation » pour plus de clarté par rapport au premier axe de polarisation de la deuxième couche 20. Cette étape d'alignement se fera par exemple au moyen des marques 12 et 32, respectivement présentes sur la première couche 10 et la troisième couche 30. Les marques 12 et 32 seront agencées de sorte que l'axe préférentiel de déformation (en particulier l'axe principal de déformation 4, ou de manière alternative, l'axe secondaire de déformation 5) soit aligné à mieux que 15° avec le deuxième axe de polarisation 31. Bien sur, les autres modes de mise en œuvre de l'étape d'alignement précédemment décrits pourront être utilisés.

Le procédé de fabrication comporte enfin une étape d'assemblage de l'empilement de couches 100 avec la troisième couche 30, de sorte que la première couche 10 soit disposée entre la deuxième 20 et la troisième couche 30. L'assemblage se fait donc entre la face libre de la première couche 10 (face opposée à celle assemblée à la deuxième couche 20) et l'une des faces de la troisième couche 30, après étalement du film ou du serpentin de colle 41 et après positionnement des marques 12 et 32 pour aligner un axe préférentiel 4,5 de déformation et le deuxième axe de polarisation 31. A titre d'exemple, le film de colle 41 est déposé sur une face de la troisième couche 30 comme illustré sur la figure 7d. Le procédé de fabrication permet d'assembler la première 10 et la troisième couche 30 de sorte qu'un axe préférentiel de déformation 4,5 soit aligné à mieux que 15° avec le deuxième axe de polarisation 31. Avantageusement, le désalignement entre ces deux axes sera même inférieur à 10°, voire à 5°.

L'empilement de couches 101 est ainsi constitué de la première couche 10 de matériau magnétostrictif disposée entre la deuxième 20 et la troisième couche 30 de matériau piézoélectrique, chacune munie d'électrodes 23,24,33,34 sur l'une au moins de leurs faces (figure 7f). L'empilement de couches 101 est remarquable en ce qu'un axe préférentiel de déformation 4,5 (préférentiellement l'axe principal de déformation 4) de la première couche 10 est aligné à mieux que 15° avec le premier 21 et le deuxième 31 axe de polarisation, respectivement de la deuxième 20 et de la troisième couche 30.

Selon un mode de mise en œuvre avantageux de l'empilement de couches 101 selon l'invention, un axe préférentiel de déformation (avantageusement l'axe principal de déformation 4) de la première couche 10 est même aligné à 2° près avec le premier 21 et le deuxième 31 axe de polarisation respectivement de la deuxième 20 et de la troisième couche 30.

La colle utilisée lors d'une étape d'assemblage pourra être choisie parmi des matériaux de différentes natures dans le but de privilégier certaines caractéristiques de l'empilement de couches 100,101. Le comportement viscoélastique de certains matériaux adhésifs sera avantageux pour absorber les différences de dilatation thermique entre les couches de matériau piézoélectrique 20,30 et la couche de matériau magnétostrictif 10. Des matériaux adhésifs plus durs et rigides seront préférés pour assurer un transfert efficace de la déformation de la première couche 10 vers les deuxième 20 et troisième 30 couches. Une interface de collage autorisant un glissement minimal entre les couches pourra alternativement être élaborée par co-frittage des couches assemblées ou encore par collage direct, sans ajout de matière adhésive.

Sans que cela soit limitatif, le matériau piézoélectrique pourra être choisi parmi le PZT, le PMN-PT, le PVDF, le BaTiO3 ou encore l'AlN.

### Convertisseur

Le convertisseur magnéto-électrique 200 selon l'invention est apte à convertir une variation d'un champ magnétique B en une différence de potentiel entre deux bornes électriques 202,203. Il comprend l'un ou l'autre des empilements de couches 100,101 tels que décrits précédemment.

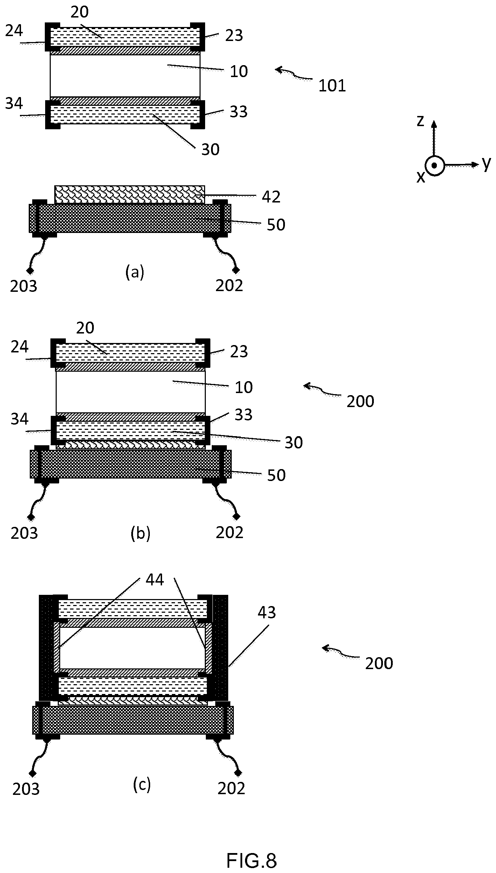

Comme cela est représenté sur les figures 8a à 8c, une borne électrique 202 est électriquement reliée à l'une des électrodes interdigitées 23,33, l'autre borne électrique 203 est reliée à l'autre des électrodes interdigitées 24,34, par exemple par l'intermédiaire d'une couche de circuit imprimé ou couche support 50 (également appelé PCB pour « printed circuit board »). La couche de circuit imprimé 50 pourra être par exemple assemblé via une couche de colle 42 à la face libre de la deuxième 20 ou de la troisième couche 30 de l'empilement de couches 100,101 (figure 8a). Comme illustré sur la figure 8a, la couche support 50 peut comporter des bornes électriques 202,203 au niveau de sa face arrière, sa face avant étant assemblée avec l'empilement de couches 100,101. Ces bornes électriques 202,203 pourront ainsi être ultérieurement connectées sur d'autres éléments, pour l'élaboration du générateur 400.

La connexion électrique entre les bornes des électrodes interdigitées 23,24,33,34 et les contacts de la couche de circuit imprimé 50 (aptes à être reliées aux deux bornes électriques qui verront la différence de potentiel) pourra être réalisée par l'intermédiaire de bandes de colle conductrice 43 déposées sur la tranche du convertisseur 200, en particulier sur la tranche de l'empilement de couches 100,101 et la tranche ou le bord de la couche support 50. Par tranche, on signifie les surfaces latérales reliant les faces principales des couches, les faces principales étant parallèles au plan (x,y) sur les figures. Les bords de couche correspondent à une partie périphérique sur une face principale. Préalablement, la tranche de la première couche 10 de matériau magnétostrictif aura été recouverte d'un film 44 de matériau isolant électriquement, notamment pour éviter que les bandes de colle conductrice 43 soient en court circuit, au contact avec la première couche 10 (figure 8c).

Alternativement, la connexion électrique entre les électrodes interdigitées 23,24,33,34 et les contacts de la couche support 50 pourra être réalisée par l'intermédiaire de câblages filaires (« wire bonding » selon la terminologie anglo-saxonne). Ces câblages filaires pourront aller de la face de la deuxième (et/ou troisième) couche 20 comportant les électrodes 23,24 ou de sa tranche vers une des faces de la couche support 50 ou sa tranche.

Alternativement, la connexion électrique entre les électrodes interdigitées 23,24,33,34 et les contacts de la couche support 50 pourra être réalisée au moyen de vias conductrices traversant l'empilement de couches (100,101).

La couche de circuit imprimé 50 aura avantageusement une forme similaire à celle de l'empilement de couches 100,101, par exemple une forme circulaire. Selon une variante, elle pourra être assemblé à un deuxième circuit imprimé comprenant des fonctions de commutation pour récolter les charges générées sur les électrodes (23,24,33,34), de stockage desdites charges, de traitement du signal électrique induit.

Selon une autre variante avantageuse, la couche de circuit imprimé 50 pourra elle-même comprendre au moins une fonction de commutateur pour récolter les charges générées sur les électrodes (23,24,33,34). Elle pourra également comprendre au moins une fonction de stockage des charges générées sur les électrodes (23,24,33,34). Elle pourra également comprendre au moins une fonction de traitement du signal électrique induit par les charges générées sur les électrodes (23,24,33,34).

Selon encore une autre variante avantageuse, une couche tampon, composée d'au moins un matériau présentant des propriétés d'absorption acoustique, est disposée entre l'empilement de couches 100,101 et la couche support 50. Cette couche tampon est assemblée, d'une part avec l'empilement 100,101 et d'autre part avec la couche support 50, via une couche de colle.

Dans le convertisseur 200, la couche tampon aura pour rôle d'absorber les ondes acoustiques qui peuvent être générées par le brusque changement de forme et/ou d'état de contrainte de la deuxième (et/ou troisième) couche en matériau piézoélectrique 20,30 qui peut s'opérer au moment de la récupération des charges sur les bornes du convertisseur 200 (la collecte des charges sera plus particulièrement abordée ci-après lors de la description du générateur). Ces ondes acoustiques se traduisent par un cliquetis audible à chaque récupération de charges et qui peut être gênant pour certaines applications. La couche tampon permet d'absorber ce son ou au moins de l'amortir significativement, éliminant ou atténuant ainsi le désagrément sonore.

Sans toutefois que cela soit limitatif, la couche tampon est avantageusement composée d'un matériau alvéolaire et en particulier à alvéoles ouvertes. A titre d'exemple, un matériau tel que la mousse de polyuréthane pourra être utilisé.

### Générateur

Pour former le générateur d'électricité 400, le convertisseur magnéto-électrique 200 peut être placé dans un logement défini par une source 300 de champ magnétique, et dans lequel règne un champ magnétique B, une partie des lignes du champ étant contenue dans un plan de référence défini par la première couche 10 en matériau magnétostrictif du convertisseur 200. On forme de la sorte un générateur 400 particulièrement compact. La source 300 de champ magnétique et le convertisseur 200 peuvent se déplacer en rotation l'un par rapport à l'autre de manière à faire varier l'orientation du champ magnétique B dans le plan de référence. Le convertisseur 200 est donc pénétré par un champ magnétique B, préférentiellement uniforme, et orienté selon une direction initiale *̅B̅*̅₀ dans le plan de référence (x,y). La variation de ce champ magnétique est destinée à être convertie en différence de potentiel entre les deux bornes électriques 202,203 du convertisseur 200.

Avantageusement, on positionnera le convertisseur dans le logement de la source 300 de champ pour que la direction initiale *̅B̅*̅₀ du champ soit parallèle à un axe préférentiel de déformation (avantageusement l'axe principal 4) de la couche 10 en matériau magnétostrictif.

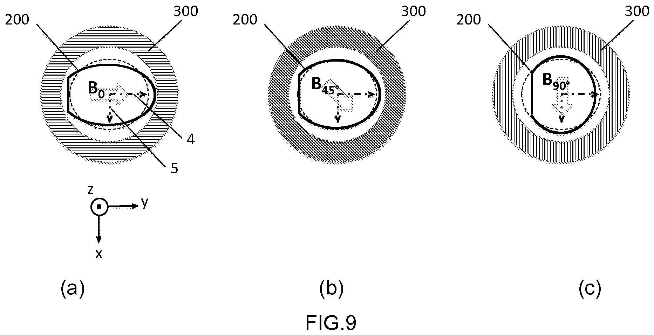

Comme illustré sur la figure 9a, sous l'action du champ magnétique *̅B̅*̅₀, la première couche 10 de matériau magnétostrictif se magnétise et subit une déformation maximale selon l'axe principal de déformation 4. Cette déformation correspond à une extension maximale de l'empilement de couches 100,101 dans le plan de référence selon l'axe principal de déformation 4 et à une contraction maximale (soit une extension négative, que l'on appellera par la suite « extension minimale ») dans le plan de référence (x,y) selon l'axe secondaire 5. La déformation de la première couche 10 est schématisée sur la figure 9a par l'ovalisation du convertisseur 200 selon l'axe principal 4. Cette déformation s'applique à la deuxième couche 20 (et, si elle est présente, à la troisième couche 30) et correspond à un état initial du convertisseur 200.

Pour réaliser une variation du champ magnétique, on fait par exemple tourner son orientation de la direction initiale *̅B̅*̅₀ jusqu'à une direction *̅B̅*̅_{45°}, dans le sens des aiguilles d'une montre (comme illustré sur la figure 9b), en déplaçant en rotation la source de champ et/ou le convertisseur. En conséquence, l'empilement de couches 100,101 du convertisseur 200 passe de son état initial à un deuxième état dans lequel :
- la première couche va se rétracter selon l'axe principal de déformation 4, passant d'une extension maximale à une extension moyenne plus faible, du fait de la diminution de la composante du champ magnétique B selon l'axe principal de déformation 4 ;
- la première couche va par ailleurs s'étendre selon l'axe secondaire de déformation 5, passant d'une extension minimale (contraction maximale) à une extension moyenne plus importante.

La variation du champ magnétique (par une rotation de sa direction) induit donc des variations de déformation de la première couche 10. Celle-ci transmet ces variations à la deuxième 20 (et potentiellement la troisième 30) couche, assemblée(s) à la première couche 10 dans l'empilement de couches 100,101.

Si on continue à faire tourner l'orientation du champ magnétique de la direction *̅B̅*̅_{45°}, jusqu'à la direction *̅B̅*̅_{90°} dans le sens des aiguilles d'une montre (comme illustré sur la figure 9c), l'empilement de couches 100,101 va passer du deuxième état à un troisième état dans lequel :
- la première couche se rétracte encore selon l'axe principal 4, passant d'une extension moyenne à une extension minimale (rétraction maximale);
- la première couche s'étend selon l'axe secondaire 5, passant d'une extension moyenne à une extension maximale selon l'axe secondaire 5, compte tenu de l'alignement du champ magnétique avec cet axe 5.

La variation du champ magnétique B entre la position initiale et la troisième position a donc induit des variations de déformation de la première couche 10, transmises à la deuxième 20 (et potentiellement la troisième 30) couche. Les deuxième 20 et troisième 30 couches de matériau piézoélectrique fonctionnent en mode d₃₃, c'est-à-dire que l'axe de polarisation est dans le plan de la couche et donc que la génération de charges dans le matériau est sensible à des déformations dans ce même plan.

Dans le cas du convertisseur 200 selon une configuration avantageuse de l'invention, les premier 21 et deuxième 31 axes de polarisation des deuxième 20 et troisième 30 couches de matériau piézoélectrique sont alignés finement (à mieux que 15°) avec l'axe principal de déformation 4 de la première couche 10. De la sorte, la deuxième 20 et la troisième 30 couches subissent le long de leur axe de polarisation 21,31, entre l'état initial et le troisième état, une déformation maximale en passant d'une extension maximale à une extension minimale (rétraction maximale). Une quantité maximale de charges (par exemple négatives) pourra donc être accumulée sur l'une des électrodes interdigitées (par exemple 23,33) et être collectée au niveau de l'une des bornes électriques 202,203 du générateur, par exemple, sur un dispositif capacitif.

Cette première séquence de variation du champ magnétique (de *̅B̅*̅₀ à *̅B̅*̅_{90°}), faisant passer le convertisseur 200 de l'état initial au troisième état peut ainsi générer une différence de potentiel entre les bornes électriques 202,203 : cette différence de potentiel est maximale grâce à la configuration du convertisseur 200 selon l'invention, garantissant une bonne efficacité du convertisseur 200, dans une configuration compacte de générateur d'électricité 400.

Après la collecte des charges au troisième état, la différence de potentiel entre les bornes électriques 202,203 est nulle et la structure de convertisseur 200 se retrouve dans un quatrième état considéré comme un nouvel état initial. La variation du champ magnétique (de *̅B̅*̅_{90°} jusqu'à *̅B̅*̅_{180°}), dans le sens des aiguilles d'une montre, va faire passer l'empilement de couche 100,101 d'un quatrième état initial à un cinquième état dans lequel :
- la première couche s'étend selon l'axe principal 4, passant d'une extension minimale à une extension maximale, compte tenu de l'alignement du champ avec l'axe principal de déformation 4.
- la première couche se rétracte selon l'axe secondaire 5, passant d'une extension maximale à une extension minimale (rétraction maximale).

La deuxième 20 (et si elle est présente, la troisième 30) couche subit le long de son axe de polarisation 21,31, entre le quatrième état initial et le cinquième état, une déformation maximale en passant d'un état d'extension minimale à un état d'extension maximale. Une quantité maximale de charges (par exemple positives) pourra donc être accumulée sur l'autre des électrodes interdigitées 24,34 et être collectée au niveau de l'autre des bornes électriques 202,203 du générateur.

L'invention propose ainsi un générateur d'électricité 400, compact comprenant un convertisseur 200 magnéto-électrique efficace, obtenu dans une configuration de champ magnétique de faible intensité ne saturant pas le matériau magnétostrictif anisotrope.

Le générateur d'électricité 400 selon l'invention présente également l'avantage d'une robustesse et une fiabilité améliorée. En effet, le convertisseur 200, soumis à des cycles répétés de déformation lors de tests d'usure et de fiabilité, a démontré dans certains cas une tenue mécanique améliorée vis-à-vis d'un convertisseur pour lequel la première couche 10 en matériau magnétostrictif travaille dans un mode de saturation magnétique. Dans une configuration de saturation magnétique, l'empilement de couches magnétostrictive / piézoélectrique peut parfois atteindre la limite de rupture mécanique au bout d'un nombre de cycles de déformation donné, par exemple 1^{E}6. En comparaison, la longévité en terme de cycles de déformation des convertisseurs 200 selon l'invention peut être augmentée d'un facteur 10 à 1000. Par ailleurs, la faible intensité du champ magnétique permet de limiter l'amplitude du couple parasite s'appliquant sur le convertisseur tendant à placer l'axe préférentiel de déformation de la couche de matériau magnétostrictif dans l'alignement du champ.

### Exemple de mise en œuvre

Selon un exemple de mise en œuvre de l'invention, des couches 10 de Terfenol-D cristallin sont fabriquées à partir d'un barreau 1 d'axe longitudinal <112>. Les couches 10 ont par exemple une épaisseur de 1 mm et un diamètre de 2 cm.

Comme détaillé précédemment, les directions cristallographiques <111> et <110> correspondant aux axes préférentiels d'aimantation 4,5 ne sont pas repérés directement sur le barreau 1, car l'orientation de ces axes au sein d'un même barreau 1 varie. Le traitement de la couche 10 de matériau magnétostrictif selon l'invention est alors mis en œuvre : il permet d'identifier, pour chaque couche 10, les axes préférentiels d'aimantation 4,5 et selon un mode de mise en œuvre, de former une marque 12 pour les repérer. A la suite de ce procédé, les couches 10 comportent par exemple une encoche 12 (appelée par la suite première encoche) sur leur tranche, s'étendant d'une face à l'autre, de quelques centaines de micromètres de profondeur. L'encoche 12 est localisée sur la direction de l'axe principal d'aimantation 4 de chaque couche 10. Alternativement, l'encoche 12 pourra être remplacée par un méplat ou encore un trait ou une gravure sur une surface des couches 10.

L'empilement de couches 101 est ensuite formé par assemblage d'une deuxième couche 20 et d'une troisième couche 30 de PZT.

Chaque couche de PZT a une épaisseur par exemple de 100 micromètres et un diamètre de 2 cm. Dans cet exemple de mise en œuvre, chaque deuxième 20 et troisième 30 couche comporte des électrodes interdigitées 23,24,33,34 sur chacune de ses faces. Une telle configuration permet de favoriser l'efficacité de génération de charges en réponse à une déformation. Ces électrodes se présentent sous forme de peignes ; les doigts des peignes sont perpendiculaires à l'axe de polarisation du matériau. Les axes de polarisation 21,31 respectivement de la deuxième 20 et de la troisième 30 couche pourront être repérés par une deuxième 22 et une troisième 32 encoche respectivement sur la deuxième 20 et la troisième 30 couche de PZT. Un film de colle 40 non conductrice électrique est déposé sur la face à assembler de la deuxième couche 20 ; la première couche 10 est positionnée au-dessus, en vis-à-vis. L'alignement entre la première encoche 12 et la deuxième encoche 22 est réalisé grâce à un appareillage permettant des déplacements micrométriques. Une pression est ensuite appliquée pour mettre en contact la première 10 et la deuxième 20 couche et étaler uniformément à l'interface le film de colle 40. La précision d'alignement permet d'aboutir à un désalignement entre l'axe principal de déformation 4 et le premier axe de polarisation 21 (de la deuxième couche) inférieur à 15°. L'empilement de couches 100 est ainsi formé.

Un film de colle 41 non conductrice électrique est ensuite déposé sur la face à assembler de la troisième couche 30 ; l'empilement de couches 100 est positionné au-dessus, la face libre de la première couche 10 en vis-à-vis avec la face encollée de la troisième couche 30. L'alignement entre la première 12 (ou la deuxième 22) encoche et la troisième encoche 32 est réalisé grâce au même appareillage que précédemment. Une pression est ensuite appliquée pour mettre en contact les faces à coller et répartir uniformément à l'interface le film de colle. La précision d'alignement permet d'obtenir un alignement entre l'axe principal de déformation 4 et le deuxième axe de polarisation 31 (de la troisième couche 30) à mieux que 15° près.

Une couche de circuit imprimé 50, de diamètre 2 cm et d'épaisseur de quelques centaines de micromètres est ensuite encollé (couche de colle 42) sur une de ses faces pour être assemblé à la face libre, par exemple, de la troisième couche 30.

Un film de colle 44 ou autre matériau non conducteur électrique est déposé pour protéger et isoler la tranche de la première couche 10 de Terfenol. Des bandes de matériau conducteur 43 (par exemple colle conductrice) sont ensuite déposées pour connecter électriquement les bornes électriques 202,203 de la couche de circuit imprimé 50 et les électrodes interdigitées 23,24,33,34 des deux couches 20,30 de PZT.

Le convertisseur magnéto-électrique 200 peut ensuite générer une différence de potentiel entre les bornes électriques 202,203, par application de variations de champ magnétique B, par exemple par l'utilisation d'un champ de direction tournante. Le générateur d'électricité 400 comporte de préférence une source 300 de champ magnétique définissant un logement à l'intérieur duquel règne un champ magnétique. Le convertisseur magnéto-électrique est disposé dans ce logement, environné dudit champ magnétique. Un mouvement de rotation relatif entre le convertisseur 200 et la source 300 de champ magnétique permet de générer la variation du champ.

De façon avantageuse, le Terfenol-D est utilisé comme matériau de la première couche 10 du convertisseur 200 car il présente deux axes préférentiels de déformation 4,5 dans le plan de référence (x,y): la mise en œuvre du générateur d'électricité 400 selon l'invention est donc très favorable dans le cas de séquences de collecte de charges après des quart de rotation.

Bien entendu, des matériaux magnétostrictifs anisotropes comportant un unique axe préférentiel de déformation dans le plan de référence pourront également être utilisés.

L'invention n'est pas limitée aux modes de réalisation décrits et on peut y apporter des variantes de réalisation sans sortir du cadre de l'invention tel que défini par les revendications.

## Revendications

1. Empilement de couches (100, 101) comprenant :
• Une première couche (10) en un matériau magnétostrictif anisotrope comportant au moins un axe préférentiel de déformation (4,5) dans le plan défini par ladite couche (10), la première couche (10) présentant au moins une marque (12), telle qu'un méplat ou une encoche sur un bord de ladite couche (10) ou une gravure sur une face de ladite couche (10), ou étant munie d'au moins un moyen de repérage, repérant un axe préférentiel de déformation (4,5) ;
• Une deuxième couche (20) d'un matériau piézoélectrique présentant un premier axe de polarisation (21) dans le plan défini par la deuxième couche (20) parallèle au plan défini par la première couche (10), le premier axe de polarisation (21) étant repéré par une deuxième marque (22) ;
Le premier axe de polarisation (21) et l'axe préférentiel de déformation (4,5) étant alignés à 15° près.

2. Empilement de couches (100, 101) selon la revendication précédente, dans lequel la deuxième couche (20) comprend des électrodes métalliques (23,24) sur l'une au moins de ses faces ou sur sa tranche.

3. Empilement de couches (100, 101) selon l'une des deux revendications précédentes, comprenant une troisième couche (30) en un matériau piézoélectrique présentant un deuxième axe de polarisation (31) dans le plan défini par la troisième couche (30), la première couche (10) étant disposée entre la deuxième couche (20) et la troisième couche (30), le deuxième axe de polarisation (31) et l'axe préférentiel de déformation (4,5) étant alignés à 15° près.

4. Empilement de couches (100, 101) selon la revendication précédente, dans lequel :
• La première couche (10) en un matériau magnétostrictif comprend un axe principal de déformation (4) et un axe secondaire de déformation (5) dans le plan défini par la couche (10) ;
• Le premier axe de polarisation (21) de la deuxième couche (20) en un matériau piézoélectrique est aligné à 15° près avec l'axe principal de déformation (4) ;
• Le deuxième axe de polarisation (31) de la troisième couche (30) en un matériau piézoélectrique est aligné à 15° près avec l'axe secondaire de déformation (5).

5. Empilement de couches (100, 101) selon l'une des quatre revendications précédentes, dans lequel le matériau piézoélectrique est composé de PZT, de PMN-PT, de PVDF, de BaTiO3 ou encore d'AlN.

6. Empilement de couches (100, 101) selon l'une des cinq revendications précédentes, dans lequel le matériau magnétostrictif est composé de Terfenol-D, de Galfenol, de Terbium Fer ou encore de Fer-Cobalt.

7. Convertisseur (200) apte à convertir une variation d'un champ magnétique (B) en une différence de potentiel entre deux bornes électriques (202,203) comprenant un empilement de couches (100, 101) selon l'une des six revendications précédentes.

8. Convertisseur (200) selon la revendication précédente, comprenant une couche de circuit imprimé assemblée avec l'empilement de couches, pour connecter la au moins une couche en matériau piézoélectrique dudit empilement aux deux bornes électriques.

9. Générateur d'électricité (400) comprenant :
• un convertisseur (200) comportant deux bornes électriques (202,203), selon l'une des deux revendications précédentes;
• une source (300) générant le champ magnétique (B) dans le plan de référence ; la source (300) de champ magnétique et le convertisseur (200) pouvant se déplacer en rotation l'un par rapport à l'autre de manière à faire varier l'orientation du champ magnétique (B) dans le plan de référence ; l'intensité du champ magnétique (B) étant insuffisante pour saturer magnétiquement le matériau de la première couche (10).

10. Générateur d'électricité (400) selon la revendication précédente, dans lequel la source (300) de champ magnétique définit un logement dans lequel règne le champ magnétique (B), le convertisseur (200) étant placé dans le logement.

11. Générateur d'électricité (400) selon l'une des deux revendications précédentes, dans lequel la source (300) de champ magnétique est un cylindre d'Halbach.

12. Procédé de fabrication d'un empilement de couches (100,101), comportant :
• une étape de fourniture d'une première couche (10) de matériau magnétostrictif anisotrope ;
• une étape d'identification d'au moins un axe préférentiel de déformation (4,5) dans le plan de référence défini par la première couche (10) ;
• une étape de fourniture d'une deuxième couche (20) d'un matériau piézoélectrique présentant un premier axe de polarisation (21) dans un plan défini par la deuxième couche (20) et repéré par une deuxième marque (22) ;
• une étape d'alignement de l'axe préférentiel de déformation (4,5) de la première couche (10) avec le premier axe de polarisation (21) de la deuxième couche (20) à 15° près;
• une étape d'assemblage de la première couche (10) avec la deuxième couche (20) pour former l'empilement de couches (100,101) .

13. Procédé de fabrication d'un empilement de couches (100,101) selon la revendication précédente, dans lequel l'étape d'identification de l'axe préférentiel de déformation (4,5) est suivie par une étape de formation d'une marque (12) sur la couche (10) pour repérer ledit axe préférentiel de déformation (4,5) .

14. Procédé de fabrication d'un empilement de couches (100,101) selon l'une des deux revendications précédentes, dans lequel l'étape d'identification de l'axe préférentiel de déformation (4,5) comprend :
• Le positionnement de la couche (10) dans un champ magnétique (b) orienté dans le plan de référence ;
• La mesure des couples requis pour déplacer la couche (10) en rotation dans le plan de référence, en une pluralité de positions angulaires ;
• La détermination d'au moins une position angulaire correspondant à un extremum de couple, pour identifier un axe préférentiel de déformation (4,5).

15. Procédé d'assemblage d'un générateur d'électricité (400) comprenant :
• la fabrication d'un empilement de couches (100,101) selon l'une des trois revendications précédentes, la première couche (10) définissant un plan de référence ;
• l'assemblage de l'empilement de couches (100,101) avec une couche de circuit imprimé (50), pour connecter la au moins une couche (20,30) de matériau piézoélectrique à deux bornes électriques (202,203) et former le convertisseur magnéto-électrique (200) ;
• le placement du convertisseur (200) dans un logement défini par une source (300) de champ magnétique, dans lequel règne un champ (B), une partie des lignes du champ étant comprise dans le plan de référence.

## Patentansprüche

1. Stapel von Schichten (100, 101) umfassend:
• Eine erste Schicht (10) aus einem anisotropen magnetostriktiven Material mit mindestens einer bevorzugten Verformungsachse (4, 5) in der durch die Schicht (10) definierten Ebene, wobei die erste Schicht (10) mindestens eine Markierung (12), wie eine Abflachung oder eine Kerbe an einem Rand der Schicht (10) oder eine Gravur auf einer Fläche der Schicht (10) aufweist oder mit mindestens einem Identifikationsmittel versehen ist, das eine bevorzugte Verformungsachse (4, 5) identifiziert;
• Eine zweite Schicht (20) aus einem piezoelektrischen Material mit einer ersten Polarisationsachse (21) in der durch die zweite Schicht (20) definierten Ebene parallel zu der durch die erste Schicht (10) definierten Ebene, wobei die erste Polarisationsachse (21) durch eine zweite Markierung (22) gekennzeichnet ist; wobei die erste Polarisationsachse (21) und die bevorzugte Verformungsachse (4,5)
auf 15° genau ausgerichtet sind.

2. Stapel von Schichten (100, 101) nach dem vorhergehenden Anspruch, wobei die zweite Schicht (20) Metallelektroden (23, 24) auf mindestens einer ihrer Flächen oder an ihrem Rand aufweist.

3. Stapel von Schichten (100, 101) nach einem der beiden vorhergehenden Ansprüche, umfassend eine dritte Schicht (30) aus einem piezoelektrischen Material mit einer zweiten Polarisationsachse (31) in der durch die dritte Schicht (30) definierten Ebene, wobei die erste Schicht (10) zwischen der zweiten Schicht (20) und der dritten Schicht (30) angeordnet ist, wobei die zweite Polarisationsachse (31) und die bevorzugte Verformungsachse (4, 5) innerhalb von 15° ausgerichtet sind.

4. Stapel von Schichten (100, 101) nach dem vorhergehenden Anspruch, wobei:
• Die erste Schicht (10) aus einem magnetostriktiven Material eine Hauptverformungsachse (4) und eine sekundäre Verformungsachse (5) in der durch die Schicht (10) definierten Ebene aufweist;
• Die erste Polarisationsachse (21) der zweiten Schicht (20) aus einem piezoelektrischen Material innerhalb von 15° mit der Hauptverformungsachse (4) ausgerichtet ist;
• Die zweite Polarisationsachse (31) der dritten Schicht (30) aus einem piezoelektrischen Material innerhalb von 15° mit der sekundären Verformungsachse (5) ausgerichtet ist.

5. Stapel von Schichten (100, 101) nach einem der vier vorhergehenden Ansprüche, wobei das piezoelektrische Material aus PZT, PMN-PT, PVDF, BaTiO3 oder AIN besteht.

6. Stapel von Schichten (100, 101) nach einem der fünf vorhergehenden Ansprüche, wobei das magnetostriktive Material aus Terfenol-D, Galfenol, Terbium-Eisen oder Eisen-Kobalt besteht.

7. Konverter (200), der in der Lage ist, eine Änderung eines Magnetfeldes (B) in eine Potentialdifferenz zwischen zwei elektrischen Anschlüssen (202, 203) umzuwandeln, umfassend einen Stapel von Schichten (100, 101) nach einem der sechs vorhergehenden Ansprüche.

8. Konverter (200) nach dem vorhergehenden Anspruch, umfassend eine gedruckte Schaltungsschicht, die mit dem Stapel von Schichten zusammengesetzt ist, zum Verbinden der mindestens einen Schicht aus piezoelektrischem Material des Stapels mit beiden elektrischen Anschlüssen.

9. Stromgenerator (400), umfassend:
• einen Konverter (200) mit zwei elektrischen Anschlüssen (202, 203), nach einem der beiden vorhergehenden Ansprüche;
• eine Quelle (300), die das Magnetfeld (B) in der Referenzebene erzeugt; wobei die Magnetfeldquelle (300) und der Konverter (200) relativ zueinander drehbar sind, um die Ausrichtung des Magnetfeldes (B) in der Referenzebene zu verändern; wobei die Stärke des Magnetfeldes (B) nicht ausreicht, um das Material der ersten Schicht (10) magnetisch zu sättigen.

10. Stromgenerator (400) nach dem vorhergehenden Anspruch, wobei die Magnetfeldquelle (300) ein Gehäuse definiert, in dem das Magnetfeld (B) präsent ist, wobei der Konverter (200) in dem Gehäuse angeordnet ist.

11. Stromgenerator (400) nach einem der beiden vorhergehenden Ansprüche, wobei die Quelle (300) des Magnetfeldes ein Halbach-Zylinder ist.

12. Verfahren zur Herstellung eines Stapels von Schichten (100, 101), Folgendes umfassend:
• einen Schritt zur Bereitstellung einer ersten Schicht (10) aus anisotropem magnetostriktivem Material;
• einen Schritt zur Identifizierung mindestens einer bevorzugten Verformungsachse (4,5) in der durch die erste Schicht (10) definierten Referenzebene;
• einen Schritt des Bereitstellens einer zweiten Schicht (20) aus einem piezoelektrischen Material mit einer ersten Polarisationsachse (21) in einer Ebene, die durch die zweite Schicht (20) definiert und durch eine zweite Markierung (22) gekennzeichnet ist;
• einen Schritt des Ausrichtens der bevorzugten Verformungsachse (4,5) der ersten Schicht (10) mit der ersten Polarisationsachse (21) der zweiten Schicht (20) bis auf 15° genau;
• einen Schritt des Zusammensetzens der ersten Schicht (10) mit der zweiten Schicht (20), um den Stapel von Schichten (100, 101) zu bilden.

13. Verfahren zur Herstellung eines Stapels von Schichten (100, 101) nach dem vorhergehenden Anspruch, wobei auf den Schritt der Identifizierung der bevorzugten Verformungsachse (4, 5) ein Schritt der Bildung einer Markierung (12) auf der Schicht (10) folgt, um die bevorzugte Verformungsachse (4, 5) zu identifizieren;

14. Verfahren zur Herstellung eines Stapels von Schichten (100, 101) nach einem der beiden vorhergehenden Ansprüche, wobei der Schritt der Identifizierung der bevorzugten Verformungsachse (4, 5) Folgendes umfasst:
• Positionieren der Schicht (10) in einem in der Referenzebene ausgerichteten Magnetfeld (b);
• Messen der Drehmomente, die erforderlich sind, um die Schicht (10) in der Referenzebene in mehreren Winkelpositionen in Rotation zu versetzen;
• Bestimmen von mindestens einer Winkelposition, die einem Drehmoment-Extremwert entspricht, um eine bevorzugte Verformungsachse zu identifizieren (4, 5).

15. Verfahren zum Zusammensetzen eines Stromgenerators (400), Folgendes umfassend:
• Herstellen eines Stapels von Schichten (100, 101) nach einem der drei vorhergehenden Ansprüche, wobei die erste Schicht (10) eine Referenzebene definiert;
• Zusammensetzen des Stapels von Schichten (100, 101) mit einer gedruckten Schaltungsschicht (50), um die mindestens eine Schicht (20, 30) aus piezoelektrischem Material mit zwei elektrischen Anschlüssen (202, 203) zu verbinden und den magnetoelektrischen Konverter (200) zu bilden;
• Anordnen des Konverters (200) in einem durch eine Magnetfeldquelle (300) definierten Gehäuse, in dem ein Feld (B) präsent ist, wobei ein Teil der Feldlinien in der Referenzebene enthalten ist.

## Claims

1. Stack of layers (100, 101), comprising:
• a first layer (10) made of an anisotropic magnetostrictive material including at least one preferential axis of deformation (4, 5) in the plane defined by said layer (10), the first layer (10) having at least one mark (12), such as a flattening or a notch on an edge of said layer (10) or an engraving on one face of said layer (10), or being provided with at least one locating means, locating a preferential axis of deformation (4, 5);
• a second layer (20) made of a piezoelectric material having a first axis of polarization (21) in the plane defined by the second layer (20) parallel to the plane defined by the first layer (10), the first axis of polarization (21) being located by a second mark (22);
the first axis of polarization (21) and the preferential axis of deformation (4, 5) being aligned to within 15°.

2. Stack of layers (100, 101) according to the preceding claim, wherein the second layer (20) comprises metal electrodes (23, 24) on at least one of its faces or on its side surface.

3. Stack of layers (100, 101) according to either of the two preceding claims, comprising a third layer (30) made of a piezoelectric material having a second axis of polarization (31) in the plane defined by the third layer (30), the first layer (10) being arranged between the second layer (20) and the third layer (30), the second axis of polarization (31) and the preferential axis of deformation (4, 5) being aligned to within 15°.

4. Stack of layers (100, 101) according to the preceding claim, wherein:
• the first layer (10) of a magnetostrictive material comprises a main axis of deformation (4) and a secondary axis of deformation (5) in the plane defined by the layer (10);
• the first axis of polarization (21) of the second layer (20) made of a piezoelectric material is aligned to within 15° with the main axis of deformation (4);
• the second axis of polarization (31) of the third layer (30) made of a piezoelectric material is aligned to within 15° with the secondary axis of deformation (5).

5. Stack of layers (100, 101) according to any of the four preceding claims, wherein the piezoelectric material is composed of PZT, PMN-PT, PVDF, BaTiO3 or even AIN.

6. Stack of layers (100, 101) according to any of the five preceding claims, wherein the magnetostrictive material is composed of terfenol-D, galfenol, terbium iron or even iron-cobalt.

7. Converter (200) for converting a variation in a magnetic field (B) into a potential difference between two electrical terminals (202, 203) comprising a stack of layers (100, 101) according to any of the six preceding claims.

8. Converter (200) according to the preceding claim, comprising a printed circuit layer assembled with the stack of layers, for connecting the at least one layer made of piezoelectric material of said stack to the two electrical terminals.

9. Electrical generator (400), comprising:
• a converter (200) including two electrical terminals (202, 203) according to either of the two preceding claims;
• a source (300) generating the magnetic field (B) in the reference plane; the source (300) of the magnetic field and the converter (200) being able to rotate with respect to one another so as to vary the orientation of the magnetic field (B) in the reference plane; the intensity of the magnetic field (B) being insufficient to magnetically saturate the material of the first layer (10).

10. Electrical generator (400) according to the preceding claim, wherein the source (300) of the magnetic field defines a housing in which the magnetic field (B) prevails, the converter (200) being placed in the housing.

11. Electrical generator (400) according to either of the two preceding claims, wherein the source (300) of the magnetic field is a Halbach cylinder.

12. Method for manufacturing a stack of layers (100, 101), including:
• a step of providing a first layer (10) made of anisotropic magnetostrictive material;
• a step of identifying at least one preferential axis of deformation (4, 5) in the reference plane defined by the first layer (10);
• a step of providing a second layer (20) made of a piezoelectric material having a first axis of polarization (21) in a plane defined by the second layer (20) and located by a second mark (22);
• a step of aligning the preferential axis of deformation (4, 5) of the first layer (10) with the first axis of polarization (21) of the second layer (20) to within 15°;
• a step of assembling the first layer (10) with the second layer (20) to form the stack of layers (100, 101).

13. Method for manufacturing a stack of layers (100, 101) according to the preceding claim, wherein the step of identifying the preferential axis of deformation (4, 5) is followed by a step of forming a mark (12) on the layer (10) for locating said preferential axis of deformation (4, 5);

14. Method for manufacturing a stack of layers (100, 101) according to either of the two preceding claims, wherein the step of identifying the preferential axis of deformation (4, 5) comprises:
• positioning the layer (10) in a magnetic field (b) oriented in the reference plane;
• measuring the torques required to rotate the layer (10) in the reference plane, in a plurality of angular positions;
• determining at least one angular position corresponding to an extremum of torque, in order to identify a preferential axis of deformation (4, 5).

15. Method for assembling an electrical generator (400), comprising:
• manufacturing a stack of layers (100, 101) according to any of the three preceding claims, the first layer (10) defining a reference plane;
• assembling the stack of layers (100, 101) with a printed circuit layer (50), in order to connect the at least one layer (20, 30) made of piezoelectric material to two electrical terminals (202, 203) and to form the magneto-electric converter (200);
• placing the converter (200) in a housing defined by a source (300) of a magnetic field, in which housing a field (B) prevails, some of the lines of the field being comprised in the reference plane.
